# EUROPEAN PATENT APPLICATION

(11) **EP 4 808 316 A2**
(43) Date of publication of application: **16.09.2026**
(21) Application number: 26188680.8
(22) Date of filing: 30.06.2026
(51) Int. Cl.: H10F 71/00, H10F 77/20

(54) **SOLAR CELL, METHOD OF MANUFACTURING SOLAR CELL, AND SOLAR CELL PRODUCTION LINE**

(30) Priority: 29.12.2025 WO PCT/CN2025/146730
(71) Applicant: LAPLACE Renewable Energy Technology Co., Ltd., Shenzhen, Guangdong 518000 (CN)
(72) Inventor: Guo, Yang, Shenzhen, 518000 (CN); Mao, Wenlong, Shenzhen, 518000 (CN); Liang, Xiao, Shenzhen, 518000 (CN); Lin, Jiaji, Shenzhen, 518000 (CN)
(74) Representative: Metida

(57) **Abstract**

A method for preparing a solar cell (100) includes providing an N-type silicon substrate (11) with alternating first regions (A1) and second regions (A2) on a first surface (11a). A first stack (12) including a first tunneling layer (121), a boron-doped polysilicon layer (122), and a first mask layer (123) is formed and selectively removed in second regions (A2) and intermediate regions (G) to create arc-shaped grooves (11r). A second stack (13) with a phosphorus-doped polysilicon layer (132) is then deposited over the entire first side. After removing wrap-around coating on the second surface (11b), portions of the second stack (13) are removed from first regions (A1) and intermediate regions (0). Finally, both mask layers (123, 133) are stripped.

## Description

### FIELD

The subject matter herein generally relates to the field of photovoltaic technology, specifically to solar cells, methods of preparing solar cells, and solar cell production lines.

### BACKGROUND

Tunnel oxide passivating contacts back contact (TBC) solar cells are a fusion of Tunnel Oxide Passivating Contacts (TOPCon) technology and Back Contact (BC) technology. However, the existing preparation process of TBC solar cells has low yield.

Therefore, there is room for improvement in the art.

### BRIEF DESCRIPTION OF THE DRAWINGS

Implementations of the present disclosure will now be described, by way of embodiment, with reference to the attached figures.
FIG. 1 is a flowchart of a method of preparing a solar cell according to an embodiment of the present disclosure.
FIG. 2 is a cross-sectional view of an N-type silicon substrate being polished on both sides in the flowchart shown in FIG. 1.
FIG. 3 is a cross-sectional view after a first tunneling layer and a first intrinsic silicon layer are formed on a first surface of the N-type silicon substrate in the flowchart shown in FIG. 1.
FIG. 4 is a cross-sectional view after a first stack is formed on the first surface of the N-type silicon substrate in the flowchart shown in FIG. 1.
FIG. 5 is a cross-sectional view of irradiating regions of a first mask layer corresponding to second regions and intermediate regions with a first laser in the flowchart shown in FIG. 1.
FIG. 6 is a plan view after grooves are formed in the N-type silicon substrate in the flowchart shown in FIG. 1.
FIG. 7 is a cross-sectional view after the grooves are formed in the N-type silicon substrate in the flowchart shown in FIG. 1.
FIG. 8 is a cross-sectional view after a second tunneling layer and a second intrinsic silicon layer are formed on a whole surface of the first surface of the N-type silicon substrate in the flowchart shown in FIG. 1.
FIG. 9 is a cross-sectional view after a second stack is formed on the first surface of the N-type silicon substrate in the flowchart shown in FIG. 1.
FIG. 10 is a cross-sectional view of irradiating regions of the second mask layer corresponding to the first regions and the intermediate regions with a second laser in the flowchart shown in FIG. 1.
FIG. 11 is a cross-sectional view after the first mask layer and the second mask layer are removed in the flowchart shown in FIG. 1.
FIG. 12 is a cross-sectional view after grid lines are formed in the flowchart shown in FIG. 1.
FIG. 13 is a schematic diagram of a solar cell production line according to an embodiment of the present disclosure.

### DETAILED DESCRIPTION

It will be appreciated that for simplicity and clarity of illustration, where appropriate, reference numerals have been repeated among the different figures to indicate corresponding or analogous elements. In addition, numerous specific details are set forth in order to provide a thorough understanding of the exemplary embodiments described herein. However, it will be understood by those of ordinary skill in the art that the exemplary embodiments described herein may be practiced without these specific details. In other instances, methods, procedures, and components have not been described in detail so as not to obscure the related relevant feature being described. Also, the description is not to be considered as limiting the scope of the exemplary embodiments described herein. The drawings are not necessarily to scale, and the proportions of certain parts may be exaggerated to better illustrate details and features of the present disclosure.

The term "comprising" when utilized, means "including, but not necessarily limited to"; it specifically indicates open-ended inclusion or membership in the so-described combination, group, series, and the like. The disclosure is illustrated by way of example and not by way of limitation in the figures of the accompanying drawings in which like references indicate similar elements. It should be noted that references to "an" or "one" embodiment in this disclosure are not necessarily to the same embodiment, and such references can mean "at least one". The term "circuit" is defined as an integrated circuit (IC) with a plurality of electric elements, such as capacitors, resistors, amplifiers, and the like.

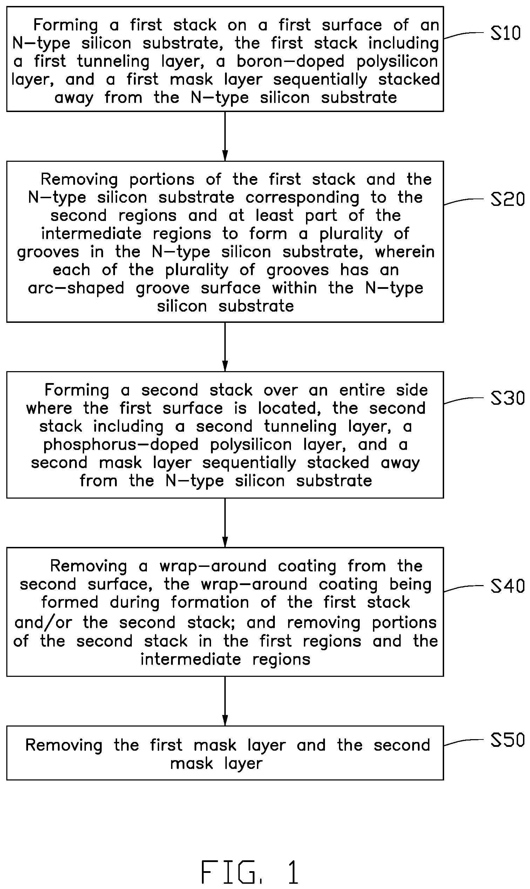

FIG. 1 illustrates a method of preparing a solar cell according to an embodiment of the present disclosure. The method of preparing the solar cell is provided by way of embodiment, as there are a variety of ways to carry out the method. The method described below can be carried out using the configurations illustrated in FIGS. 1 through 12 for example, and various elements of these figures are referenced in explaining the method. Each block in this method represents one or more processes, methods, or subroutines, carried out in the method. Additionally, the illustrated order of blocks is by example only, the order of the blocks can change, and certain blocks or sub-blocks can be omitted or combined. The method can begin at Block S10 of FIG. 1.

In Block S10, a first stack is formed on a first surface of an N-type silicon substrate, the first stack includes a first tunneling layer, a boron-doped polysilicon layer, and a first mask layer sequentially stacked away from the N-type silicon substrate.

In some embodiments, the Block S10 includes the following Blocks S11 to S13.

In Block S11, double-sided polishing is carried out on the N-type silicon substrate by using a wet processing apparatus.

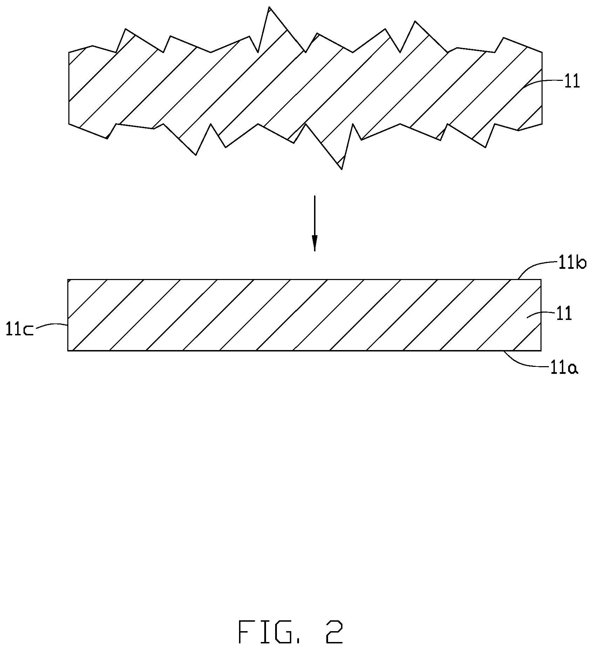

As shown in FIG. 2, the N-type silicon substrate 11 includes a first surface 11a and a second surface 11b opposite to each other, and side surfaces 11c connecting the first surface 11a and the second surface 11b. After double-sided polishing, the first surface 11a and the second surface 11b of the N-type silicon substrate 11 are flat. It should be noted that the N-type silicon substrate 11 is hereinafter also referred to as a silicon wafer, the first surface 11a of the N-type silicon substrate 11 is referred to as a back surface, and the second surface 11b of the N-type silicon substrate 11 is referred to as a front surface.

In some embodiments, the wet processing apparatus includes a wet alkaline cleaning apparatus. The Block S11 includes loading the N-type silicon substrate 11 into a first carrier basket, placing the first carrier basket carrying the N-type silicon substrate 11 into the wet alkaline cleaning apparatus, and performing double-sided polishing on the N-type silicon substrate 11 through an alkaline cleaning step, so as to facilitate a subsequent deposition of a polysilicon layer on surfaces of the N-type silicon substrate 11.

In some embodiments, the wet processing apparatus further includes a wet texturing apparatus, which can perform a texturing treatment on the second surface 11b of the N-type silicon substrate 11. A textured surface after the texturing treatment can be a preliminary textured surface, meaning that a secondary texturing treatment can be subsequently performed to form a final textured surface. The textured surface after the texturing treatment can also directly form the final textured surface.

In Block S12, a first tunneling layer and a first intrinsic silicon layer are sequentially formed on the first surface by low-pressure chemical vapor deposition (LPCVD).

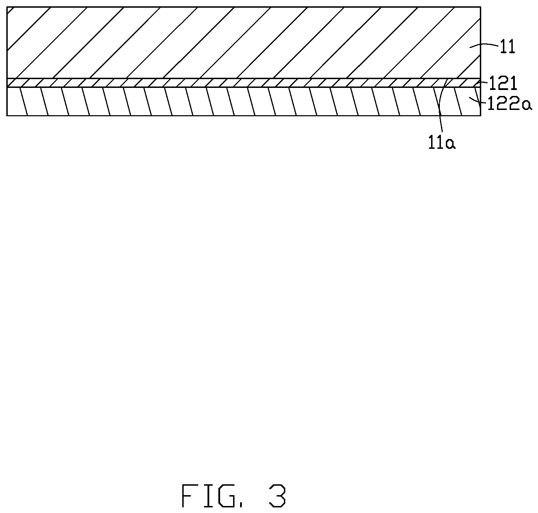

As shown in FIG. 3, the first tunneling layer 121 is on the first surface 11a, and the first intrinsic silicon layer 122a is on a surface of the first tunneling layer 121 away from the first surface 11a.

In some embodiments, a first boat carrying at least one silicon wafer is placed into a furnace tube of a first LPCVD apparatus, a furnace door of the first LPCVD apparatus is sealed, vacuum is pulled, and a temperature in the furnace tube is raised. Then, process gases are introduced to deposit the first tunneling layer 121 (e.g., SiO₂ with a thickness of 1 nm to 2 nm) and the first intrinsic silicon layer 122a on the first surface 11a of the silicon wafer.

It should be noted that during a deposition of the first tunneling layer 121 and the first intrinsic silicon layer 122a on the first surface 11a, wrap-around deposition is likely to occur, that is, the tunneling layer and the intrinsic silicon layer are also deposited on the second surface 11b and the side surfaces 11c between the first surface 11a and the second surface 11b. The wrap-around deposited tunneling layer and intrinsic silicon layer can be removed in subsequent processes.

In some embodiments, the deposition of the first tunneling layer 121 and the first intrinsic silicon layer 122a is performed in two steps. After depositing the first tunneling layer 121, the furnace tube of the first LPCVD apparatus is purged, and then a silicon source is introduced to deposit the first intrinsic silicon layer 122a.

In some embodiments, the process of depositing the first intrinsic silicon layer 122a is divided into two times, performed intermittently in the first LPCVD apparatus, to generate a thicker first intrinsic silicon layer 122a. Specifically, after depositing a portion of the first intrinsic silicon layer 122a in the first LPCVD apparatus, the furnace tube of the first LPCVD apparatus is purged. The first LPCVD apparatus is evacuated and heated again, and then process gases are introduced to deposit another portion of the first intrinsic silicon layer 122a.

After the deposition of the first intrinsic silicon layer 122a is completed in the first LPCVD, the first boat carrying the silicon wafers is taken out from the furnace of the first LPCVD apparatus. The silicon wafers after the first LPCVD process are taken out and loaded into a second carrier basket. The operation time from when the unprocessed silicon wafers enter the first LPCVD apparatus to when the silicon wafers after the first LPCVD process are taken out and loaded into the second carrier basket can be, but is not limited to, 240 min.

In some embodiments, a processing temperature of the first LPCVD apparatus is increased, so that the first intrinsic silicon layer 122a is an intrinsic polysilicon layer. In some embodiments, the processing temperature of the first LPCVD apparatus is decreased, so that the first intrinsic silicon layer 122a is an intrinsic silicon layer mixed with intrinsic polysilicon and intrinsic amorphous silicon, or even the first intrinsic silicon layer 122a is an intrinsic amorphous silicon layer.

In Block S13, a boron diffusion treatment on the first intrinsic silicon layer is performed to convert the first intrinsic silicon layer into a boron-doped polysilicon layer, and a borosilicate glass (BSG) layer is formed on a surface of the boron-doped polysilicon layer, wherein the first mask layer includes the BSG layer.

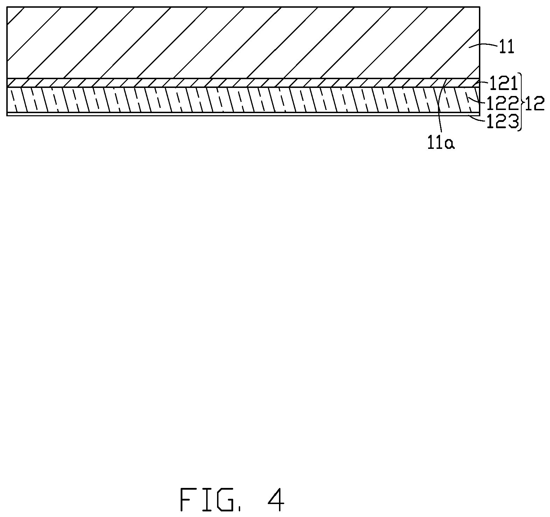

As shown in FIG. 4, the first stack 12 includes the first tunneling layer 121, the boron-doped polysilicon layer 122, and the first mask layer 123.

In some embodiments, in addition to the BSG layer, the first mask layer 123 may further include an additionally formed silicon oxide layer, etc.

In some embodiments, a second carrier basket is transported to a first diffusion apparatus, and the silicon wafers are taken out from the second carrier basket and placed into a second boat. The second boat carrying the silicon wafers is placed into a furnace tube of the first diffusion apparatus, a furnace door of the first diffusion apparatus is sealed, and a temperature of the furnace tube is raised, then a boron source is introduced. The temperature of the furnace tube is adjusted so that the BSG layer is formed on the surface of the first intrinsic silicon layer 122a on the first surface 11a of the silicon wafer. Boron elements diffuse inward through the BSG layer, causing the intrinsic silicon layer to be doped with boron elements to form a P-poly layer (i.e., boron-doped polysilicon layer). During this process, crystal grains grow more robustly, making regions not irradiated by laser in subsequent steps less susceptible to damage during a laser grooving step. The second boat carrying the silicon wafers after the boron diffusion process is taken out from the furnace of the first diffusion apparatus, and the silicon wafers after the boron diffusion process are taken out and loaded into a third carrier basket. The P-poly layer formed in this step forms a P-N junction with the silicon wafer. The operation time for this action can be, but is not limited to, 140 min.

When the first intrinsic silicon layer 122a contains amorphous silicon, the amorphous silicon can also crystallize into polysilicon after high-temperature treatment in the first diffusion apparatus.

The first surface includes a plurality of first regions, a plurality of second regions, and a plurality of intermediate regions. Each first region alternates with a corresponding second region, and each intermediate region is between a first region of the plurality of first regions and the corresponding second region. In Block S20, the first stack and the N-type silicon substrate in each second region, and at least a portion of the first stack and the N-type silicon substrate in each intermediate region, are removed, thereby forming a plurality of grooves within the N-type silicon substrate, and a groove surface of each groove in the N-type silicon substrate is arc-shaped.

In some embodiments, Block S20 includes the following Blocks S21 to S22.

In Block S21, a first laser is used to irradiate the regions on the first mask layer corresponding to the second regions and the intermediate regions.

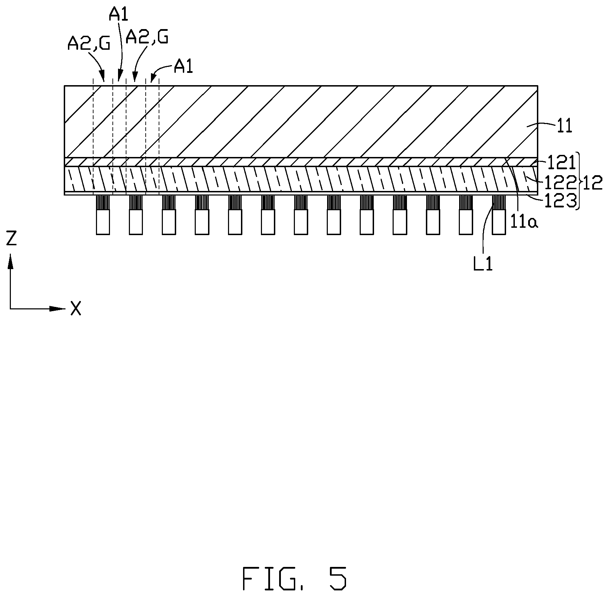

As shown in FIG. 5, the first regions A1 and the second regions A2 are alternately arranged along a first direction X, and the first direction X is perpendicular to a thickness direction Z of the N-type silicon substrate 11. There is one intermediate region G between each adjacent first region A1 and second region A2. The first laser L1 irradiates the positions on the first mask layer 123 corresponding to each second region A2 and at least a portion of each intermediate region G, while the positions on the first mask layer 123 corresponding to each first regions A1 are not irradiated by the first laser L1.

In some embodiments, the silicon wafers after the boron diffusion process are taken out from the third carrier basket and placed on a conveyor belt of a first laser apparatus, with the first surface 11a of the silicon wafers facing a laser generator of the first laser apparatus. The laser generator of the first laser apparatus emits a dot-matrix laser to scan each second region A2 and at least a portion of each intermediate region G on the first surface 11a of the silicon wafers, while keeping the first regions A1 unirradiated. The silicon wafers with the second regions A2 and the intermediate regions G having been irradiated by the laser are taken out from the first laser apparatus and placed into a fourth carrier basket.

In some embodiments, the silicon wafers after the boron diffusion process are taken from the third carrier basket and sucked into a positioning structure of the first laser apparatus, with the first surface 11a of the silicon wafers facing the laser generator of the first laser apparatus. The laser generator of the first laser apparatus emits a dot-matrix laser to scan each second region A2 and at least a portion of each intermediate region G on the first surface 11a of the silicon wafers, while keeping the first regions A1 unirradiated. The silicon wafers with the second regions A2 and the intermediate regions G having been irradiated by the laser are taken out from the positioning structure of the first laser apparatus and placed into a fourth carrier basket.

In Block S22, the first stack beneath the regions irradiated by the first laser and portions of the N-type silicon substrate beneath the regions irradiated by the first laser are removed by an alkaline etching process to form the grooves.

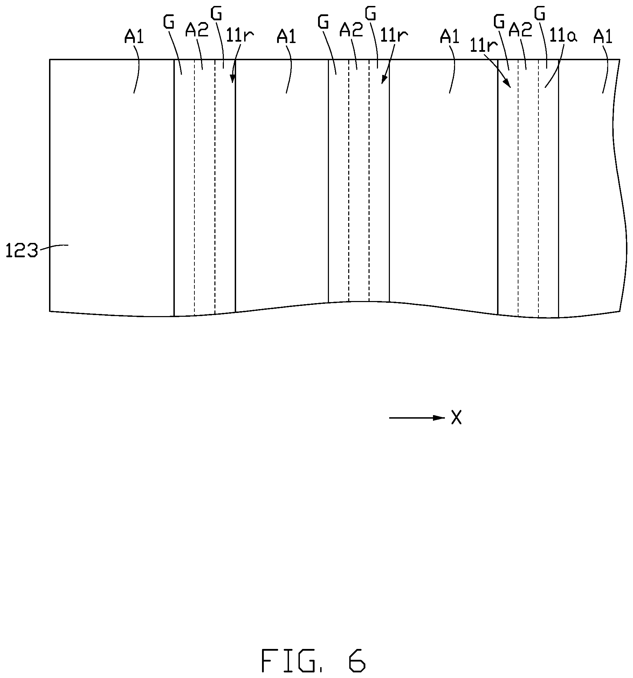

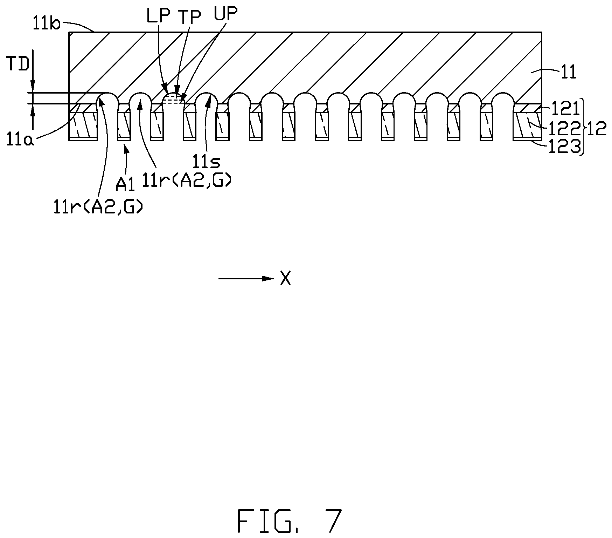

Please refer to FIG. 6 and FIG. 7. The first stack 12 in the second regions A2 and the intermediate regions G is removed, and the N-type silicon substrate 11 in the second regions A2 and the intermediate regions G is partially etched, forming the grooves 11r. The first stack 12 in the first regions A1 is retained due to a protection of the first mask layer 123. The groove surfaces formed by the grooves 11r within the N-type silicon substrate are arc-shaped. The arc shape is convex towards the second surface 11b.

In some embodiments, the fourth carrier basket is transported to a first alkaline cleaning apparatus, and the silicon wafers carried by the fourth carrier basket that have been irradiated by the laser are placed into the first alkaline cleaning apparatus for the alkaline etching process.

Since the BSG layer in the second regions A2 and the intermediate regions G is formed into a loose structure by laser irradiation, the BSG layer in the second regions A2 and the intermediate regions G is washed away during the first alkaline cleaning process, and the P-poly layer located beneath the BSG layer in the second regions A2 and the intermediate regions G is etched. The first tunneling layer 121 is silicon oxide, which etches slowly in alkaline solution of the alkaline etching process compared to silicon. However, on one hand, a thickness of the first tunneling layer 121 is about 2 nm, which is thin enough, and on the other hand, a duration of alkaline etching is extended, allowing the alkaline solution to etch through the first tunneling layer 121 and cause the grooves 11r to roughly present a smooth, water-drop shape, i.e., the groove surfaces formed by the grooves 11r in the N-type silicon substrate are arc-shaped rather than pointed or flat. The fourth carrier basket is taken out from the first alkaline cleaning apparatus.

It should be noted that the first regions A1 are not etched by the alkaline polishing due to the protection of the dense BSG layer, and the BSG layer in the first regions A1 also protect the P-poly layer and the first tunneling layer 121 underneath. It can be understood that a composition of the alkaline solution in each alkaline etching process may vary slightly. However, a person skilled in art, based on the need to etch through the first tunneling layer 121 and etch the silicon substrate into a water-drop shape, can determine a corresponding etching time through experiments with the alkaline solution used.

In some embodiments, in a cross-sectional view, each water-drop shaped groove 11r has a cross-sectional profile that, in a direction from the first surface 11a toward an interior of the N-type silicon substrate 11, first forms a narrowed opening with a small curvature, and then the curvature increases.

In some embodiments, a plurality of protrusions is formed after the alkaline etching on the groove surface of each water-drop shaped groove 11r. A distribution of the protrusions on the groove surface is non-uniform along a depth direction (i.e., the thickness direction Z of the N-type silicon substrate 11) of the groove 11r. Specifically, in an upper portion UP of the water-drop shaped groove 11r extending from the first surface 11a to an upper inner surface 11s at a depth no greater than 20% of a total depth (TD) of the water-drop shaped groove 11r, for example approximately 20% of the total depth, the protrusions on the upper inner surface 11s have a relatively large average size less than 3 µm. A transition region TP is defined in a middle portion of the groove 11r, in which a density and an average size of the protrusions gradually decrease along a direction from the first surface 11a toward an interior of the N-type silicon substrate 11, with the average size of the protrusions in the transition region TP being less than 2 µm. In a lower portion LP of the groove 11r proximate a bottom of the groove 11r, the protrusions are sparsely distributed or substantially absent, such that the groove surface in the lower portion LP is relatively smooth.

In some embodiments, each of the plurality of protrusions is a pyramid-shaped structure.

In some embodiments, the first alkaline cleaning apparatus is a chain-type alkaline cleaning apparatus. In some embodiments, the first alkaline cleaning apparatus is a tank-type alkaline cleaning apparatus.

By making the groove surfaces formed by the grooves 11r in the N-type silicon substrate arc-shaped, an effective area of a subsequently formed second tunneling layer 131 can be increased, thereby increasing majority carrier tunneling current. In addition, the arc-shaped groove surfaces of the grooves 11r also allow the second tunneling layer 131 to be conformally deposited along a curved profile, such that the second tunneling layer 131 extends with a vertical component relative to the first surface 11a, which can reduce lateral carrier transport losses, and improve carrier lifetime and utilization rate. Furthermore, the arc-shaped groove surfaces of the grooves 11r can reduce mechanical stress concentration, thereby reducing a breakage rate.

In Block S30, a second stack is formed over an entire side where the first surface is located, the second stack includes a second tunneling layer, a phosphorus-doped polysilicon layer, and a second mask layer sequentially stacked in the direction away from the N-type silicon substrate.

In some embodiments, the Block S30 includes the following Blocks S31 to S32.

In Block S31, a second tunneling layer and a second intrinsic silicon layer are sequentially formed on the side where the first surface is located by LPCVD.

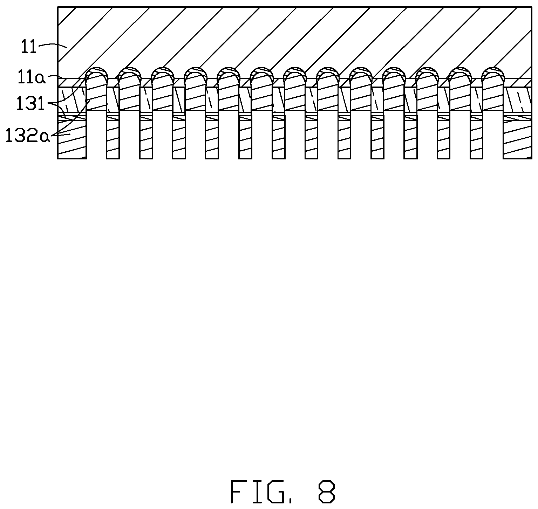

As shown in FIG. 8, each of the second tunneling layer 131 and the second intrinsic silicon layer 132a is formed over the entire surface on the side where the first surface 11a of the N-type silicon substrate 11 is located.

In some embodiments, the fourth carrier basket is transported to the second LPCVD apparatus, the silicon wafers that have undergone the alkaline etching process in the fourth carrier basket are transferred to a third boat, and then the third boat carrying the silicon wafers is placed into a furnace tube of a second LPCVD apparatus. The furnace door of the second LPCVD apparatus is sealed, vacuum is pulled, and a temperature of the second LPCVD apparatus is raised. Then, process gases are introduced for a deposition of the second tunneling layer 131 and the second intrinsic silicon layer 132a. The second tunneling layer 131 and the second intrinsic silicon layer 132a are deposited on the silicon wafers (in the previous first alkaline cleaning step, the first tunneling layer 121 in the second regions A2 and the intermediate regions G was etched through, exposing the silicon substrate in those regions, while the first tunneling layer 121 in the first regions A1 remained protected by the BSG layer.).

In some embodiments, the deposition of the second tunneling layer 131 and the second intrinsic silicon layer 132a is performed in two steps. After depositing the second tunneling layer 131, the furnace tube of the second LPCVD apparatus is purged, and then a silicon source is introduced to deposit the second intrinsic silicon layer 132a.

In some embodiments, the process of depositing the second intrinsic silicon layer 132a is performed in two steps to generate a thicker second intrinsic silicon layer 132a. The third boat carrying the silicon wafers after the second LPCVD process is taken out from the furnace of the second LPCVD apparatus, and the silicon wafers after the second LPCVD process are taken out and loaded into a fifth carrier basket. An operation time for the entire step S31 can be, but is not limited to, 140 min.

In some embodiments, the processing temperature of the second LPCVD apparatus is increased, so that the second intrinsic silicon layer 132a is an intrinsic polysilicon layer. In some embodiments, the processing temperature of the second LPCVD apparatus is decreased, so that the second intrinsic silicon layer 132a is an intrinsic silicon layer mixed with intrinsic polysilicon and intrinsic amorphous silicon, or even so that the second intrinsic silicon layer 132a is an intrinsic amorphous silicon layer.

In Block S32, a phosphorus diffusion treatment is performed on the second intrinsic silicon layer to convert the second intrinsic silicon layer into a phosphorus-doped polysilicon layer, and form a phosphosilicate glass (PSG) layer on a surface of the phosphorus-doped polysilicon layer, wherein the second mask layer includes the phosphosilicate glass layer.

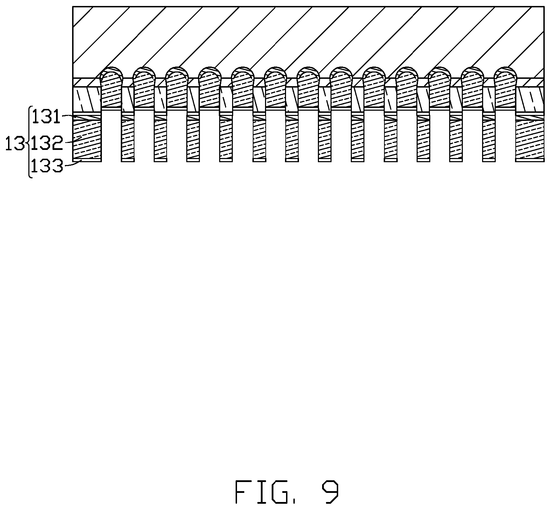

As shown in FIG. 9, the second stack 13 includes the second tunneling layer 131, the phosphorus-doped polysilicon layer 132, and the second mask layer 133.

In some embodiments, the fifth carrier basket is transported to a second diffusion apparatus, and the silicon wafers after the second LPCVD process are taken out from the fifth carrier basket and placed into a fourth boat. The fourth boat carrying the silicon wafers after the second LPCVD process is placed into a furnace tube of the second diffusion apparatus, a furnace door of the second diffusion apparatus is sealed and a temperature of the second diffusion apparatus is raised, then a phosphorus source is introduced, and the temperature is adjusted so that the PSG layer is formed on the surface of the second intrinsic silicon layer 132a on the side where the first surface 11a of the silicon wafer is located. Phosphorus elements diffuse inward through the PSG layer, causing the second intrinsic silicon layer 132a to be doped with phosphorus elements to form an N-poly layer (i.e., the phosphorus-doped polysilicon layer 132). During this process, the crystal grains grow more robustly, making the regions not irradiated by laser in subsequent steps less susceptible to damage during the laser grooving step.

Thereafter, the fourth boat carrying the silicon wafers after the phosphorus diffusion process is taken out from the furnace of the second diffusion apparatus, and the silicon wafers after the phosphorus diffusion process are taken out and loaded into a sixth carrier basket. The N-poly layer formed in this step constitutes an N+ layer (a heavily doped phosphorus layer), which creates field passivation, reduces carrier recombination. At the same time, the electric field can drive a directional flow of majority and minority carriers. An operation time for this process can be, but is not limited to, 140 min.

When the second intrinsic silicon layer 132a contains amorphous silicon, the amorphous silicon can also crystallize into polysilicon after high-temperature treatment in the second diffusion apparatus.

In Block S40, a wrap-around coating layer formed on the second surface of the N-type silicon substrate during a formation of the first stack and/or a formation of the second stack is removed; and the corresponding portions of the second stack in the first regions and the intermediate regions are removed.

In some embodiments, Block S40 includes the following Blocks S41 to S43.

In Block S41, a second laser is used to irradiate regions on the second mask layer corresponding to the first regions and the intermediate regions.

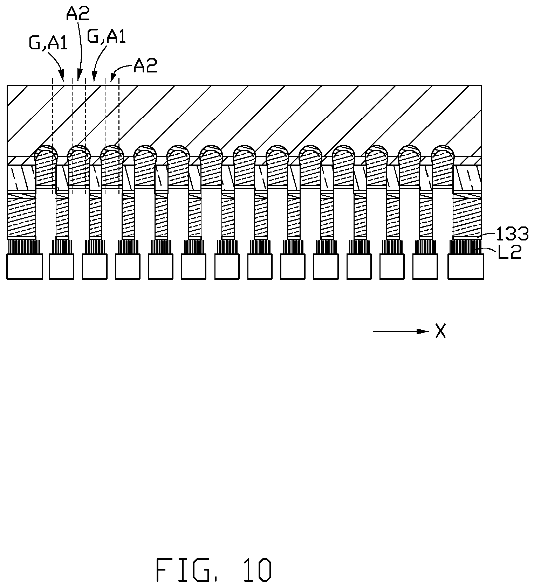

As shown in FIG. 10, the regions on the second mask layer 133 corresponding to the first regions A1 and the intermediate regions G are irradiated by the second laser L2, while the portions of the second mask layer 133 corresponding to the second regions A2 are not irradiated by the second laser L2.

In some embodiments, the silicon wafers are taken out from the sixth carrier basket and placed on a conveyor belt of the second laser apparatus, with the first surface 11a of the silicon wafers facing a laser generator of the second laser apparatus. The laser generator of the second laser apparatus emits a dot-matrix laser to scan each first region A1 and at least a portion of each intermediate region G on the first surface 11a of the silicon wafer, while keeping the second regions A2 unirradiated. The silicon wafers with the first regions A1 and the intermediate regions G having been irradiated by the laser are taken out from the second laser apparatus and placed into a seventh carrier basket.

In some embodiments, the silicon wafers after the phosphorus diffusion process are taken out from the sixth carrier basket and sucked into a positioning structure of the second laser apparatus, with the first surface 11a of the silicon wafers facing the laser generator of the second laser apparatus. The laser generator of the second laser apparatus emits a dot-matrix laser to scan the first regions A1 and at least a portion of each intermediate region G on the first surface 11a of the silicon wafers, while keeping the second regions A2 unirradiated. The silicon wafers with the first regions A1 and at least a portion of each intermediate region G having been irradiated by the laser are removed from the positioning structure of the second laser apparatus and placed into a seventh carrier basket.

In Block S42, the wrap-around coating formed on the second surface 11b of the N-type silicon substrate 11 during the formation of the first stack 12 and/or the formation of the second stack 13 is removed. In some embodiments, the wrap-around coating includes the first stack 12 wrap-around coated on the second surface 11b of the N-type silicon substrate 11 when forming the first stack 12. In some embodiments, the wrap-around coating includes the second stack 13 wrap-around coated on the second surface 11b when forming the second stack 13. In some embodiments, the wrap-around coating includes the first stack 12 wrap-around coated on the second surface 11b of the N-type silicon substrate 11 when forming the first stack 12 and the second stack 13 wrap-around coated on the second surface 11b when forming the second stack 13.

In some embodiments, the seventh carrier basket is transported to an acid cleaning apparatus, the silicon wafers from the seventh carrier basket are placed into the acid cleaning apparatus with the second surface 11b of the silicon wafers is oriented downward to contact an acidic cleaning agent in the acid cleaning apparatus. Through the acid cleaning apparatus, the wrap-around coating on the second surface 11b of the silicon wafers is removed. Thereafter, the silicon wafers are taken out from the acid cleaning apparatus and placed into an eighth carrier basket.

In some embodiments, the acid cleaning apparatus is a chain-type acid cleaning apparatus. In some embodiments, the acid cleaning apparatus is a tank-type acid cleaning apparatus.

The silicon wafers are rinsed after the acid cleaning and before the alkaline etching process.

In Block S43, through an alkaline etching process, the second stack beneath the regions irradiated by the second laser is removed and simultaneously the second surface and exposed portions of the first surface in the intermediate regions are textured.

In some embodiments, during the alkaline etching process, the portions of the second mask layer 133 corresponding to the first regions A1 and the intermediate regions G are removed, and at the same time, the second stack 13 in the first regions A1 and the intermediate regions G is etched, and a textured surface is formed on the second surface 11b and the exposed portion of the first surface 11a in the intermediate regions G.

In Block S50, the first mask layer is removed, and the second mask layer is removed.

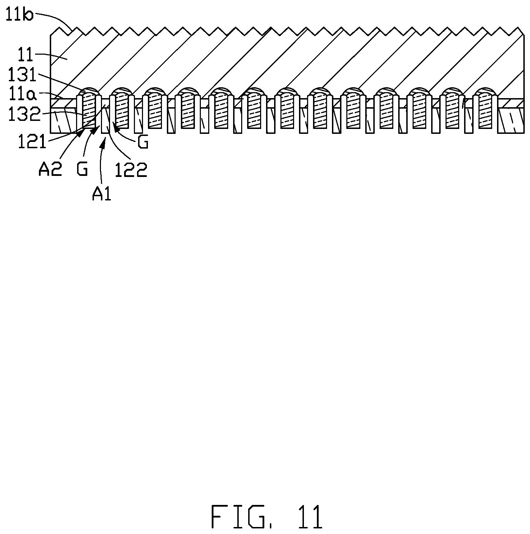

In some embodiments, after the Block S43, an acid cleaning process is performed to remove the first mask layer 123 remaining in the first regions A1 and the second mask layer 133 remaining in the second regions A2, thereby obtaining a structure shown in FIG. 11.

In some embodiments, the eighth carrier basket is transported to a second alkaline cleaning apparatus, and the eighth carrier basket is directly placed into the second alkaline cleaning apparatus for processing. The front surfaces of the silicon wafers are textured by a first cleaning agent. The second regions A2 on the back surfaces of the silicon wafers, which were not irradiated by the second laser apparatus, are not corroded by the first cleaning agent due to the masking protection of the PSG layer. However, the PSG layer in the first regions A1 and the intermediate regions G is broken up by the laser, so the PSG layer in the first regions A1 and the intermediate regions G will fall off, and the N-poly layer, P-poly layer, and the underlying first tunneling layer 121 and second tunneling layer 131 in the first regions A1 and the intermediate regions G are etched, forming isolation grooves, so that the P-poly layer in the first regions A1 is directly insulated from the N-poly layer in the second regions A2. Thereafter, the PSG layer and the BSG layer on the back surfaces of the silicon wafers are removed by a second cleaning agent.

In some embodiments, the second alkaline cleaning apparatus is a chain-type alkaline cleaning apparatus. In some embodiments, the second alkaline cleaning apparatus is a tank-type alkaline cleaning apparatus.

It can be understood that the alkaline etching process can further include the following: if a preliminary textured surface was formed on the second surface 11b after the processing of the wet processing apparatus in Block S11, then between the first cleaning agent and the second cleaning agent, a third cleaning agent can be used to perform a secondary texturing treatment on the second surface 11b and the bottom of the isolation grooves to form a textured surface at the bottom of the isolation grooves and a final textured surface on the second surface 11b. By adjusting the composition of the first cleaning agent, the first cleaning agent can also simultaneously have a function of alkaline cleaning the N-poly layer, P-poly layer, and the underlying first tunneling layer 121 and second tunneling layer 131, as well as a function of texturing the second surface 11b and the bottom of the isolation grooves.

In some embodiments, after removing the first mask layer and the second mask layer, at least one of the following is further included: forming a first passivation layer on the side where the first surface is located and forming a second passivation layer on a side where the second surface is located; forming a first anti-reflection layer on the side where the first surface is located and forming a second anti-reflection layer on the side where the second surface is located; providing a plurality of grid lines on the side where the first surface is located. The plurality of grid lines includes a plurality of first grid lines and a plurality of second grid lines. The first grid lines are in electrical contact with the boron-doped polysilicon layer, and the second grid lines are in electrical contact with the phosphorus-doped polysilicon layer. Thus, a solar cell is obtained.

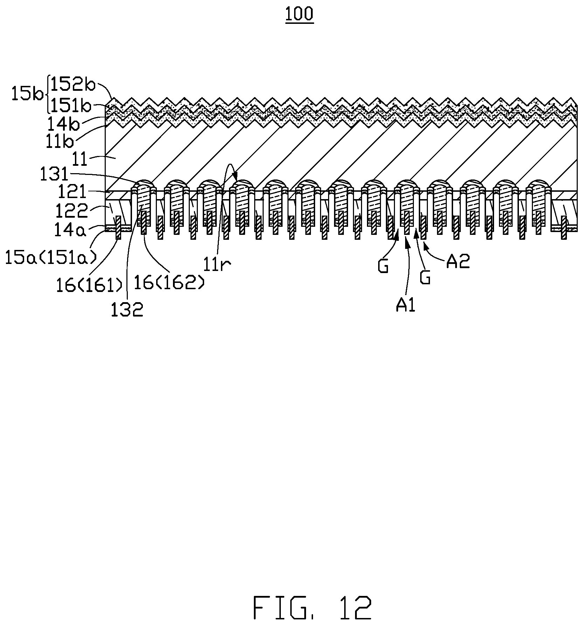

As shown in FIG. 12, a solar cell 100 includes the N-type silicon substrate 11, the first tunneling layer 121, the boron-doped polysilicon layer 122, the second tunneling layer 131, the phosphorus-doped polysilicon layer 132, and the grid lines 16 including the first grid lines 161 and the second grid lines 162.

The N-type silicon substrate 11 has a first surface 11a and a second surface 11b opposite to each other. The first surface 11a defines alternately arranged first regions A1, second regions A2, and intermediate regions G between adjacent first regions A1 and second regions A2. Each groove 11r with arc-shaped groove surface is provided at a position of the second region A2 and the intermediate region G.

The first tunneling layer 121 and the boron-doped polysilicon layer 122 are both in the first regions A1. The first tunneling layer 121 is in contact with the first surface 11a, and the boron-doped polysilicon layer 122 is on top of the first tunneling layer 121.

The second tunneling layer 131 and the phosphorus-doped polysilicon layer 132 are both in the second regions A2. The second tunneling layer 131 is in contact with the groove surfaces of the grooves 11r, and the phosphorus-doped polysilicon layer 132 is on the second tunneling layer 131.

Some of the grid lines 16 (i.e., the first grid lines 161) are in electrical contact with the boron-doped polysilicon layer 122, and some of the grid lines 16 (i.e., the second grid lines 162) are in electrical contact with the phosphorus-doped polysilicon layer 132.

The solar cell 100 further includes a first passivation layer 14a. The first passivation layer 14a covers the boron-doped polysilicon layer 122, the phosphorus-doped polysilicon layer 132, and the surface of the N-type silicon substrate 11 exposed in the intermediate regions G.

The solar cell 100 further includes a second passivation layer 14b. The second passivation layer 14b is formed on the second surface 11b of the N-type silicon substrate 11.

In some embodiments, the first passivation layer 14a can be, but is not limited to, aluminum oxide, and the second passivation layer 14b can be, but is not limited to, aluminum oxide.

In some embodiments, the eighth carrier basket is transported to a passivation layer deposition apparatus. The passivation layer deposition apparatus can be an Atomic Layer Deposition (ALD) apparatus. The silicon wafers from the eighth carrier basket are transferred to a fifth boat, and the fifth boat carrying the silicon wafers is placed into a furnace tube of the ALD apparatus. The furnace door of the ALD apparatus is sealed, vacuum is pulled, and the temperature of ALD apparatus is raised. Then, process gases are introduced for the deposition of an aluminum oxide passivation layer. The aluminum oxide passivation layer is deposited on a front side and a back side of each silicon wafer. The fifth boat carrying the silicon wafers with the deposited aluminum oxide passivation layer is taken out from the furnace of the ALD apparatus, and the silicon wafers are taken out and loaded into a ninth carrier basket.

The solar cell 100 further includes a first anti-reflection layer 15a and a second anti-reflection layer 15b. The first anti-reflection layer 15a is on the first passivation layer 14a. The second anti-reflection layer 15b is on the second passivation layer 14b.

In some embodiments, the first anti-reflection layer 15a includes a first silicon nitride layer 151a. The second anti-reflection layer 15b includes a second silicon nitride layer 151b and a silicon oxide layer 152b sequentially stacked in the direction away from the N-type silicon substrate 11.

In some embodiments, forming the first anti-reflection layer 15a and the second anti-reflection layer 15b includes using a first Plasma Enhanced Chemical Vapor Deposition (PECVD) apparatus to form the first silicon nitride layer 151a and the second silicon nitride layer 151b; then using a second PECVD apparatus to form the silicon oxide layer 152b.

In other embodiments, forming the first anti-reflection layer 15a and the second anti-reflection layer 15b includes forming the first silicon nitride layer 151a and the second silicon nitride layer 151b in the first PECVD apparatus; then forming the silicon oxide layer 152b in the first PECVD apparatus.

In some embodiments, the ninth carrier basket is transported to the first PECVD apparatus. The silicon wafers from the ninth carrier basket are transferred to a sixth boat, and the sixth boat carrying the silicon wafers is placed into a furnace tube of the first PECVD apparatus. The furnace door of the first PECVD apparatus is sealed, vacuum is pulled, and the temperature of the first PECVD apparatus is raised. Then, process gases are introduced, and a glow discharge is generated for the deposition of the first silicon nitride layer 151a and the second silicon nitride layer 151b. The first silicon nitride layer 151a on the front side of the silicon wafer can not only play a passivation role but also reduce reflection and improve light absorption rate. The second silicon nitride layer 151b on the back side of the silicon wafer forms a passivation layer. Thereafter, the sixth boat carrying the silicon wafers with the deposited silicon nitride layer is taken out from the furnace of the first PECVD apparatus, and the silicon wafers are taken out and loaded into a tenth carrier basket.

In some embodiments, the tenth carrier basket is transported to the second PECVD apparatus. The silicon wafers from the tenth carrier basket are transferred to a seventh boat, and the seventh boat carrying the silicon wafers is placed into a furnace tube of the second PECVD apparatus. The furnace door of the second PECVD apparatus is sealed, vacuum is pulled, and the temperature of the second PECVD apparatus is raised. Then, process gases are introduced, and a glow discharge is generated for the deposition of the silicon oxide layer 152b. The silicon oxide layer 152b on the front side of the silicon wafer can increase light transmittance, improve light absorption, and protect the inner structure. The seventh boat carrying the silicon wafers with the deposited silicon oxide layer 152b is taken out from the furnace of the second PECVD apparatus, and the silicon wafers are taken out and loaded into an eleventh carrier basket for subsequent patterning and emitter processes.

It can be understood that the first through ninth carrier baskets can be distinguished or not distinguished according to actual scheduling. When not distinguished, the carrier baskets used for carrying silicon wafers between various areas can be used interchangeably.

It should be noted that existing TBC solar cell production lines have long commissioning processes, long investment periods, and relatively complex production processes with low yield rates. Especially in TBC cells produced by PECVD processes, the in-situ grown polysilicon is very prone to micro-cracks and polysilicon damage during laser grooving, which affects an open-circuit voltage and conversion efficiency of the finished TBC cells. Moreover, a connection between existing LPCVD processes and other process steps is not sufficiently coherent, resulting in a discontinuous process flow and low production efficiency. Inappropriate LPCVD processes also face the problem of being prone to micro-cracks and polysilicon damage during laser grooving, thereby affecting the open-circuit voltage and conversion efficiency of the finished TBC cells.

In the method of preparing the solar cell according to the embodiments of the present disclosure, the first tunneling layer under the P-poly layer and the second tunneling layer under the N-poly layer are formed separately. Both sides of the first tunneling layer and both sides of the second tunneling layer have better connection interfaces, effectively reducing defects, lowering carrier recombination, and improving conversion efficiency. In addition, through two LPCVD processes, intrinsic silicon is deposited separately, and through two diffusion apparatus, boron diffusion and phosphorus diffusion are performed separately to form the P-poly layer and the N-poly layer, making the polysilicon deposition uniform, reducing surface defects, decreasing the occurrence of dangling bonds, and further improving conversion efficiency. Furthermore, the groove surfaces of the grooves are arc-shaped and roughly water-drop shaped. On one hand, this is beneficial for reducing mechanical stress concentration, thereby reducing the breakage rate of the solar cells. On the other hand, it achieves a balance between insulation effect and the formation of leakage channels.

The embodiment of present disclosure further provides a solar cell production line. The solar cell production line can be used to execute the above method of preparing a solar cell.

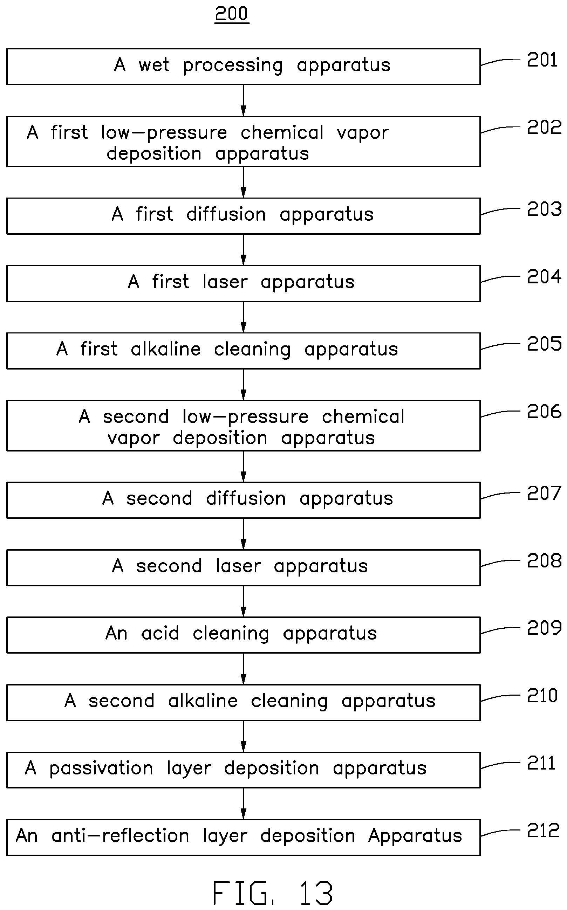

As shown in FIG. 13, the solar cell production line 200 includes sequentially connected a wet processing apparatus 201, a first low-pressure chemical vapor deposition (LPCVD)apparatus 202, a first diffusion apparatus 203, a first laser apparatus 204, a first alkaline cleaning apparatus 205, a second low-pressure chemical vapor deposition (LPCVD) apparatus 206, a second diffusion apparatus 207, a second laser apparatus 208, an acid cleaning apparatus 209, a second alkaline cleaning apparatus 210, a passivation layer deposition apparatus 211, and an anti-reflection layer deposition apparatus 212.

The wet processing apparatus 201 is configured to perform double-sided polishing on the N-type silicon substrate 11. The N-type silicon substrate 11 has opposite first surface 11a and second surface 11b. The first surface 11a is defined with alternately arranged first regions A1, second regions A2, and intermediate regions G between adjacent first regions A1 and second regions A2.

The first LPCVD apparatus 202 is configured to sequentially form the first tunneling layer 121 and the first intrinsic silicon layer 122a on the first surface 11a.

The first diffusion apparatus 203 is configured to convert the first intrinsic silicon layer 122a into the boron-doped polysilicon layer 122 through a boron diffusion treatment and form a BSG layer as the first mask layer 123, thereby obtaining the first stack 12.

The first laser apparatus 204 is configured to emit the first laser L1 to irradiate the regions on the first mask layer 123 corresponding to the second regions A2 and the intermediate regions G.

The first alkaline cleaning apparatus 205 is configured to remove the first stack 12 and a portion of the N-type silicon substrate 11 beneath the regions irradiated by the first laser L1 through alkaline etching to form the grooves 11r with arc-shaped groove surfaces.

The second LPCVD apparatus 206 is configured to sequentially form the second tunneling layer 131 and the second intrinsic silicon layer 132a on the side where the first surface 11a is located.

The second diffusion apparatus 207 is configured to convert the second intrinsic silicon layer 132a into the phosphorus-doped polysilicon layer 132 through a phosphorus diffusion treatment and form a phosphosilicate glass layer as the second mask layer 133, thereby obtaining the second stack 13.

The second laser apparatus 208 is configured to emit the second laser L2 to irradiate the regions on the second mask layer 133 corresponding to the first regions A1 and the intermediate regions G.

The acid cleaning apparatus 209 is configured to remove the wrap-around coating formed on the second surface 11b of the N-type silicon substrate 11 during the formation of the first stack 12 and/or the second stack 13. The wrap-around coating includes the first stack 12 wrap-around coated on the second surface 11b and/or the second stack 13 wrap-around coated on the second surface 11b.

The second alkaline cleaning apparatus 210 includes a polishing section and a texturing section. The polishing section is configured to remove the second stack 13 beneath the regions irradiated by the second laser L2. The texturing section is configured to perform texturing of the second surface 11b and the exposed portions of the first surface 11a in the intermediate regions G.

It can be understood that a texturing machine can further be included between the wet processing apparatus 201 and the first LPCVD apparatus 202. After the N-type silicon substrate 11 is double-sided polished by the wet processing apparatus 201, a textured surface is prepared on at least the second surface 11b of the N-type silicon substrate 11 by the texturing machine. If the textured surface prepared by the texturing machine on the second surface 11b of the N-type silicon substrate 11 is a preliminary textured surface, then the N-type silicon substrate 11 can undergo secondary texturing in the second alkaline cleaning apparatus 210 to form the final textured surface. If the textured surface prepared by the texturing machine on the second surface 11b of the N-type silicon substrate 11 is the final textured surface, it may not need to go through the texturing of the second alkaline cleaning apparatus 210.

The passivation layer deposition apparatus 211 is configured to form a first passivation layer 14a on the side where the first surface 11a is located and forming the second passivation layer 14b on the side where the second surface 11b is located. The passivation layer deposition apparatus 211 can be, but is not limited to, an ALD apparatus.

The anti-reflection layer deposition apparatus 212 is configured to form the first anti-reflection layer 15a on the side where the first surface 11a is located and form the second anti-reflection layer 15b on the side where the second surface 11b is located.

In some embodiments, the first laser apparatus 204 and the second laser apparatus 208 can be a same apparatus, and AGV robots can be used to transport the silicon wafers from the second diffusion apparatus 207 back to the first laser apparatus 204 (in one embodiment, i.e., the second laser apparatus 208) to perform the laser process.

In some embodiments, the first LPCVD apparatus 202 and the second LPCVD apparatus 206 can be a same apparatus, and AGV robots can be used to transport the silicon wafers from the first alkaline cleaning apparatus 205 back to the first LPCVD apparatus 202 (in one embodiment, the second LPCVD apparatus 206) to perform the deposition process.

In some embodiments, the first anti-reflection layer 15a includes the first silicon nitride layer 151a. The second anti-reflection layer 15b includes the second silicon nitride layer 151b and the silicon oxide layer 152b stacked in sequence. The anti-reflection layer deposition apparatus 212 includes a first PECVD apparatus and a second PECVD apparatus. Forming the first anti-reflection layer 15a and the second anti-reflection layer 15b includes using the first PECVD apparatus to form the first silicon nitride layer 151a and the second silicon nitride layer 151b; then using the second PECVD apparatus to form the silicon oxide layer 152b.

In other embodiments, the anti-reflection layer deposition apparatus 212 includes the first PECVD apparatus, and the second PECVD apparatus can be omitted. Forming the first anti-reflection layer 15a and the second anti-reflection layer 15b includes forming the first silicon nitride layer 151a and the second silicon nitride layer 151b in the first PECVD apparatus; then forming the silicon oxide layer 152b in the first PECVD apparatus.

In some embodiments, the structure and process parameters of each apparatus included in the solar cell production line 200 can be referred to the description of the method of preparing the solar cell above and will not be repeated here.

It is to be understood, even though information and advantages of the present exemplary embodiments have been set forth in the foregoing description, together with details of the structures and functions of the present exemplary embodiments, the disclosure is illustrative only. Changes may be made in detail, especially in matters of shape, size, and arrangement of parts within the principles of the present exemplary embodiments to the full extent indicated by the plain meaning of the terms in which the appended claims are expressed.

## Claims

1. A method of preparing a solar cell (100), comprising:
providing an N-type silicon substrate (11) having a first surface (11a) and a second surface (11b) opposite to the first surface (11a), the first surface (11a) comprising a plurality of first regions (A1), a plurality of second regions (A2), and a plurality of intermediate regions (G), each of the plurality of first regions (A1) alternates with a corresponding second region of the plurality of second regions (A2), and each of the plurality of intermediate regions (G) is between a first region of the plurality of first regions (A1) and the corresponding second region (A2);
forming a first stack (12) on the first surface (11a), wherein the first stack (12) comprises a first tunneling layer (121), a boron-doped polysilicon layer (122), and a first mask layer (123) sequentially stacked away from the N-type silicon substrate (11);
removing portions of the first stack (12) and the N-type silicon substrate (11) corresponding to the plurality of second regions (A2) and at least part of the plurality of intermediate regions (G) to form a plurality of grooves (11r) in the N-type silicon substrate (11), wherein each of the plurality of grooves (11r) has an arc-shaped groove surface within the N-type silicon substrate (11);
forming a second stack (13) over an entire side where the first surface (11a) is located, the second stack (13) comprising a second tunneling layer (131), a phosphorus-doped polysilicon layer (132), and a second mask layer (133) sequentially stacked away from the N-type silicon substrate (11);
removing a wrap-around coating from the second surface (11b), the wrap-around coating being formed during formation of the first stack (12) and/or the second stack (13); and removing portions of the second stack (13) in the plurality of first regions (A1) and the plurality of intermediate regions (G); and
removing the first mask layer (123) and removing the second mask layer (133).

2. The method as claimed in claim 1, wherein forming the plurality of grooves (11r) comprises:
irradiating regions of the first mask layer (123) corresponding to the plurality of second regions (A2) and the at least part of the plurality of intermediate regions (G) with a first laser (L1); and
removing, through an alkaline etching process, the first stack (12) and a portion of the N-type silicon substrate (11) beneath the regions irradiated by the first laser (L1) to form the plurality of grooves (11r), wherein in a cross-sectional view, the arc-shaped groove surface of each of the plurality of grooves (11r) is convex toward the second surface (11b).

3. The method as claimed in claim 1, wherein forming the first stack (12) comprises:
sequentially forming the first tunneling layer (121) and a first intrinsic silicon layer (122a) on the first surface (11a) by low-pressure chemical vapor deposition (LPCVD); and
performing boron diffusion on the first intrinsic silicon layer (122a) to convert the first intrinsic silicon layer (122a) into the boron-doped polysilicon layer (122) while forming a borosilicate glass layer (BSG) on the boron-doped polysilicon layer (122), wherein the first mask layer (123) comprises the BSG layer.

4. The method as claimed in claim 1, wherein forming the second stack (13) comprises:
sequentially forming the second tunneling layer (131) and a second intrinsic silicon layer (132a) over the entire side where the first surface (11a) is located by LPCVD; and
performing phosphorus diffusion on the second intrinsic silicon layer (132a) to convert the second intrinsic silicon layer (132a) into the phosphorus-doped polysilicon layer (132) while forming a phosphosilicate glass (PSG) layer on the phosphorus-doped polysilicon layer (132), wherein the second mask layer (133) comprises the PSG layer.

5. The method as claimed in claim 1, wherein removing the second stack (13) in the plurality of first regions (A1) and the plurality of intermediate regions (G) comprises:
irradiating regions on the second mask layer (133) corresponding to the plurality of first regions (A1) and the plurality of intermediate regions (G) with a second laser (L2); and
removing the second stack (13) beneath the regions irradiated by the second laser (L2) through an alkaline etching process while simultaneously texturing the second surface (11b) and exposed portions of the first surface (11a) in the plurality of intermediate regions (G).

6. The method as claimed in claim 2, wherein after the alkaline etching process, each of the plurality of grooves (11r) has a groove surface comprising pyramidal structures, and a density of the pyramidal structures decreases in a direction from the first surface (11a) toward an interior of the N-type silicon substrate (11).

7. The method as claimed in claim 2, wherein after the alkaline etching process, a plurality of protrusions is formed on the arc-shaped groove surface of each of the plurality of grooves (11r), and a distribution of the plurality of protrusions on the arc-shaped groove surface is non-uniform along a depth direction of each respective groove (11r); wherein:
in an upper portion (UP) of the arc-shaped groove extending from the first surface (11a) to an upper inner surface (11s) no greater than 20% of a total depth (TD) of each of the plurality of grooves (11r), the plurality of protrusions on the upper inner surface (11s) has an average size less than 3 µm;
in a transition region (TP) of each respective groove (11r) below the upper portion (UP), a density and an average size of the plurality of protrusions gradually decrease along a direction from the first surface (11a) toward an interior of the N-type silicon substrate (11), with the average size of the plurality of protrusions in the transition region (TP) being less than 2 µm.

8. The method as claimed in any one of claims 1 to 7, further comprising at least one of the following:
forming a first passivation layer (14a) on the side of the first surface (11a) and forming a second passivation layer (14b) on a side of the second surface (11b) after removing the first mask layer (123) and the second mask layer (133);
forming a first anti-reflection layer (15a) on the side of the first surface (11a) and forming a second anti-reflection layer (15b) on the side of the second surface (11b) after removing the first mask layer (123) and the second mask layer (133);providing a plurality of first grid lines (161) and a plurality of second grid lines (162) on the side of the first surface (11a) after removing the first mask layer (123) and the second mask layer (133), wherein the plurality of first grid lines (161) is in electrical contact with the boron-doped polysilicon layer (122), and the plurality of second grid lines (162) is in electrical contact with the phosphorus-doped polysilicon layer (132).

9. A solar cell (100), comprising:
an N-type silicon substrate (11) having a first surface (11a) and a second surface (11b) opposite to the first surface (11a), wherein the first surface (11a) comprises a plurality of first regions (A1), a plurality of second regions (A2), and a plurality of intermediate regions (G), each of the plurality of first regions (A1) alternates with a corresponding second region of the plurality of second regions (A2), and each of the plurality of intermediate regions (G) is between a first region of the plurality of first regions (A1) and the corresponding second region (A2), the N-type silicon substrate (11) comprises a plurality of grooves (11r) in the plurality of second regions (A2) and the plurality of intermediate regions (G), and each of the plurality of grooves (11r) has an arc-shaped groove surface within the N-type silicon substrate (11);
a first tunneling layer (121) in contact with the first surface (11a) in the plurality of first regions (A1);
a boron-doped polysilicon layer (122) on the first tunneling layer (121) in the plurality of first regions (A1);
a second tunneling layer (131) in contact with the groove surface of each of the plurality of grooves (11r) and in the plurality of second regions (A2);
a phosphorus-doped polysilicon layer (132) on the second tunneling layer (131) and in the plurality of second regions (A2);
a plurality of first grid lines (161) in electrical contact with the boron-doped polysilicon layer (122); and
a plurality of second grid lines (162) in electrical contact with the phosphorus-doped polysilicon layer (132).

10. The solar cell (100) as claimed in claim 9, further comprising a first passivation layer (14a) covering the boron-doped polysilicon layer (122), the phosphorus-doped polysilicon layer (132), and an exposed surface of the N-type silicon substrate (11) in the plurality of intermediate regions (G).

11. A solar cell production line (200) of manufacturing the solar cell (100) as claimed in claim 9, comprising:
a wet processing apparatus (201) performing double-sided polishing on the N-type silicon substrate (11);
a first low-pressure chemical vapor deposition apparatus (LPCVD) (202) sequentially forming the first tunneling layer (121) and a first intrinsic silicon layer (122a) on the first surface (11a);
a first diffusion apparatus (203) performing boron diffusion to convert the first intrinsic silicon layer (122a) into the boron-doped polysilicon layer (122) and forming a borosilicate glass layer as the first mask layer (123);
a first laser apparatus (204) emitting a first laser (L1) to irradiate regions of the first mask layer (123) corresponding to the plurality of second regions (A2) and at least part of a plurality of intermediate regions (G);
a first alkaline cleaning apparatus (205) forming a plurality of grooves (11r) with arc-shaped groove surfaces by removing portions of a first stack (12) and the N-type silicon substrate (11) beneath the regions irradiated by the first laser (L1), the first stack (12) comprising the first tunneling layer (121), the boron-doped polysilicon layer (122), and the first mask layer (123) sequentially stacked away from the N-type silicon substrate (11);
a second LPCVD apparatus (206) sequentially forming the second tunneling layer (131) and a second intrinsic silicon layer (132a) on a side of the first surface (11a);
a second diffusion apparatus (207) converting the second intrinsic silicon layer (132a) into the phosphorus-doped polysilicon layer (132) through a phosphorus diffusion treatment, and forming a phosphosilicate glass layer as a second mask layer (133), thereby obtaining a second stack (13);
a second laser apparatus (208) emitting a second laser (L2) to irradiate regions of the second mask layer (133) corresponding to the plurality of first regions (A1) and the plurality of intermediate regions (G);
an acid cleaning apparatus (209) removing a first stack (12) wrap-around coated on the second surface (11b) and a second stack (13) wrap-around coated on the second surface (11b);
a second alkaline cleaning apparatus (210) removing the second stack (13) beneath the regions irradiated by the second laser (L2), texturing at least exposed portions of the first surface (11a) in the plurality of intermediate regions (G), and removing the first mask layer (123) and the second mask layer (133);
a passivation layer deposition apparatus (211) forming a first passivation layer (14a) on the side of the first surface (11a) and forming a second passivation layer (14b) on the side of the second surface (11b); and
an anti-reflection layer deposition apparatus (212) forming a first anti-reflection layer (15a) on the side of the first surface (11a) and forming a second anti-reflection layer (15b) on the side of the second surface (11b).

12. The solar cell production line (200) as claimed in claim 11, further comprising a texturing machine between the wet processing apparatus (201) and the first low-pressure chemical vapor deposition apparatus (202), and the texturing machine textures at least the second surface (11b) of the N-type silicon substrate (11).

13. The solar cell production line (200) as claimed in claim 11, wherein the second alkaline cleaning apparatus (210) further textures the second surface (11b) while texturing the exposed portions of the first surface (11a) in the plurality of intermediate regions (G).

14. The solar cell production line (200) as claimed in claim 11, wherein the anti-reflection layer deposition apparatus (212) comprises:
a first plasma-enhanced chemical vapor deposition (PECVD) apparatus forming a first silicon nitride layer (151a) as the first anti-reflection layer (15a) and a second silicon nitride layer (151b) on the second surface (11b); and
a second PECVD apparatus forming a silicon oxide layer (152b) on the second silicon nitride layer (151b), wherein the second anti-reflection layer (15b) comprises the second silicon nitride layer (151b) and the silicon oxide layer (152b).

15. The solar cell production line (200) as claimed in claim 11, wherein the anti-reflection layer deposition apparatus (212) comprises a first plasma-enhanced chemical vapor deposition (PECVD) apparatus forming a first silicon nitride layer (151a) as the first anti-reflection layer (15a), a second silicon nitride layer (151b) on the second surface (11b), and a silicon oxide layer (152b) on the second silicon nitride layer (151b), wherein the second anti-reflection layer (15b) comprises the second silicon nitride layer (151b) and the silicon oxide layer (152b).
